Europäisches Patentamt

European Patent Office

Office européen des brevets

(19)

(11) Veröffentlichungsnummer: **0 034 282**
**B1**

(12)

# EUROPÄISCHE PATENTSCHRIFT

(45) Veröffentlichungstag der Patentschrift:
03.10.84

(51) Int. Cl.³: **H 01 L 23/40**

(21) Anmeldenummer: **81100640.2**

(22) Anmeldetag: **29.01.81**

(54) **Kühlkörperblock für Halbleiter-Scheibenzellen.**

(30) Priorität: **14.02.80 DE 3005505**

(43) Veröffentlichungstag der Anmeldung:
**26.08.81 Patentblatt 81/34**

(45) Bekanntmachung des Hinweises auf die Patenterteilung:
**03.10.84 Patentblatt 84/40**

(84) Benannte Vertragsstaaten:
**CH DE FR IT LI**

(56) Entgegenhaltungen:
**DE - A - 2 362 353**
**DE - A - 2 611 260**
**FR - A - 2 131 846**

(73) Patentinhaber: **Licentia Patent-Verwaltungs-GmbH,
Theodor-Stern-Kai 1, D-6000 Frankfurt/Main 70 (DE)**

(72) Erfinder: **Lenze, Friedel, Kirchtal 17,
D-4784 Rüthen 3 (DE)**
Erfinder: **Martinetz, Hans, Nachtigallenweg 34,
D-4788 Warstein 2 (DE)**
Erfinder: **Strünkmann, Jörg, Ing. grad.,
Josef-Löbbecke-Strasse 16, D-4788 Warstein 2 (DE)**

(74) Vertreter: **Lertes, Kurt, Dr. et al, Licentia
Patent-Verwaltungs-GmbH Theodor-Stern-Kai 1,
D-6000 Frankfurt/M 70 (DE)**

## Beschreibung

Die Erfindung bezieht sich auf einen Kühlkörperblock mit zwei Kühlkörpern, die mit einer oder mit mehreren zwischen sich an ebenen Auflageflächen unter Kontaktdruck eingespannten Halbleiter-Scheibenzellen zusammengehalten sind, mit jeweils einem an den vorderen und den hinteren Stirnseiten der zwei Kühlkörper angefügten Formteil aus einem Isolierkunststoff.

Kühlkörperblöcke der vorangehend beschriebenen Art mit darin eingespannten Halbleiter-Scheibenzellen, nämlich sogenannte Dioden- und Thyristorblöcke, sind bekannt, z. B. durch Siemens Datenbuch 1977, Gleichrichtersätze, Teil 5 – Blöcke, Säulen, Baugruppen – Seite 44, Massbild 2.6.

Derartige Kühlkörperblöcke mit je zwei Kühlkörpern haben zwischen denselben jeweils an den vorderen und den hinteren Stirnseiten der Kühlkörper angefügte Formteile aus einem Isolierkunststoff. Längs der zwei Breitseiten eines jeden Formteils sind Durchgangslöcher eingeformt. Derart ausgebildet, dienen die zwei Formteile als Halterung eines Kühlkörperblocks, wobei jedes Formteil oben und unten zwischen zwei von den zwei Kühlkörpern abstehenden Laschen eingefügt ist und selbst wird jedes Formteil von zwei Stangen getragen, die durch die Durchgangslöcher hindurchgesteckt sind.

Von den beschriebenen Kühlkörperblöcken werden die Stirnseiten durch die Formteile nicht voll überdeckt. Die Formteile können auch nicht an bereits montierten Kühlkörpern mit dazwischen eingespannten Halbleiterzellen angebracht oder davon entfernt werden. Das Aneinanderreihen von Kühlkörpern ist nicht ohne Verwendung zusätzlicher Mittel, wie Distanzstücke, möglich.

Mithin stellt sich die Aufgabe, die der Erfindung zugrunde liegt, eine Konstruktion der Formteile und Kühlkörper bei einem Kühlkörperblock mit den eingangs angegebenen Merkmalen anzugeben, durch die die oben vorangehend erläuterten Nachteile vermieden werden und wodurch in einfacher Weise, d. h. ohne Aufwand an Konstruktionsteilen, Isolierplatten am Kühlkörperblock anbringbar sind, sowie auch mehrere Kühlkörperblöcke, z. B. auf Gewindestangen und ohne Zuhilfenahme von Distanzstücken, in Kraftschluss miteinander so aneinandergereiht werden können, dass keine unerwünschten Kräfte auf die Kühlkörper und somit die Halbleiterzellen übertragen werden können.

Durch die im Patentanspruch 1 gekennzeichneten Merkmale wird die der Erfindung zugrundeliegende Aufgabe dadurch gelöst, dass die an den Stirnseiten der zwei Kühlkörper angefügten Formteile Rahmen sind mit geraden Mittenschenkeln, welche den freien Raum zwischen den einander zugewandten Kühlrippen der Kühlkörper abschliessen, und mit Aussenschenkeln, welche jeweils den halben freien Raum zwischen den Kühlrippen der Kühlkörper benachbart angeordneter Kühlkörperblöcke abschliessen, und dass die zwei Formteile jeweils mittels zweier von je einem Durchbruch, die beide durch den Mittenschenkel voneinander getrennt sind, umfasster und aus den Formteilen herausragender C-förmiger Schienen, die als elektrische Anschlussspuren der zwei Kühlkörper dienen und von denen jeweils eine an jeder Stirnseite jedes Kühlkörpers angeformt ist, an gegenüberliegenden Stirnseiten des Kühlblocks verriegelbar sind.

Die an den Kühlkörpern angebrachten Formteile aus Isolierkunststoff erhalten, einer weiteren Ausbildung der Erfindung entsprechend, dadurch einen «angepassten Sitz» an den C-förmigen Schienen, dass die Kühlkörper des Blocks in den Formteilen gelagert sind, dass diese Formteile zu ihrer Verriegelung je zwei an der Innenfläche der zwei Aussenschenkel angeformte federnde Haken haben, die längs je einer C-förmigen Schiene aussen anliegen und die die äusseren Längskanten zum Boden der betreffenden Schiene einrastend umgreifen und die Formteile am Kühlkörperblock verankern.

Einer weiteren Ausgestaltung der Erfindung gemäss haben die zwei Aussenschenkel der Formteile an den Seitflächen, welche den Kühlkörpern zugewandt sind, je eine Führung zum Einschieben von Isolierplatten, die zusammen mit den zwei Formteilen eine den Kühlkörper schachtartig umschliessende Umkleidung bilden.

Vorteilhaft können damit an Kühlkörperblöcken einzeln Kühlluftschächte festgelegt werden. Die Isolierplatten dienen ferner zur elektrischen Isolation der einzelnen in Aneinanderreihung angeordneten Kühlkörperblöcke voneinander.

Die an den vorderen und den hinteren Stirnseiten der zwei Kühlkörper angeformten C-förmigen Schienen können unterschiedlich hoch sein und unterschiedlich weit aus den Durchbrüchen der Formteile herausragen. Je nachdem, wie die zwei Kühlkörper in bezug aufeinander angeordnet werden, ergeben sich an den zwei Stirnflächen der Kühlkörper gleich oder verschieden weit davon beabstandete Anschlussebenen. Zumeist lassen sich damit die Blöcke als Bestandteile von Stromrichter-Geräten einfacher miteinander verschienen.

Ein Ausführungsbeispiel der Erfindung ist in der Zeichnung dargestellt und nachstehend beschrieben. Es zeigt

Fig. 1 einen erfindungsgemässen Kühlkörperblock mit einem Formteil als Rahmen und mit Anschlussspuren in Draufsicht auf eine Stirnseite des Blocks und auf das Formteil;

Fig. 2a einen erfindungsgemässen Kühlkörperblock mit zwei Kühlkörpern und den zwei daran angebrachten Formteilen in einer Seitenansicht in Richtung des Kühlluftstromes;

Fig. 2b einen Teilschnitt A–B nach Fig. 1;

Fig. 3 eine Draufsicht auf die Rückseite eines Formteils nach Fig. 1 bis Fig. 2b.

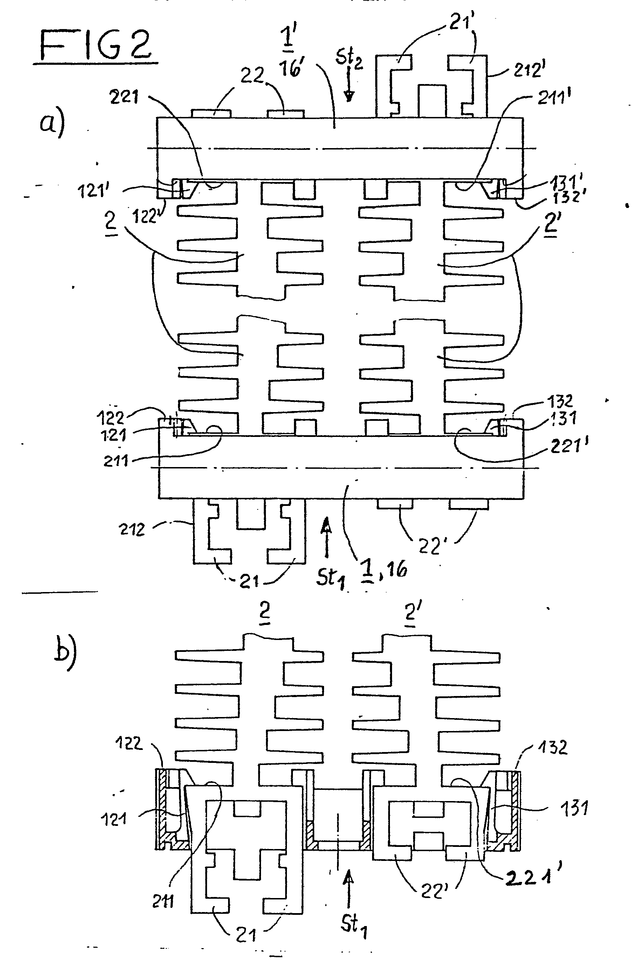

In der Fig. 2 ist der mittlere Teil des Kühlkörperblocks weggelassen.

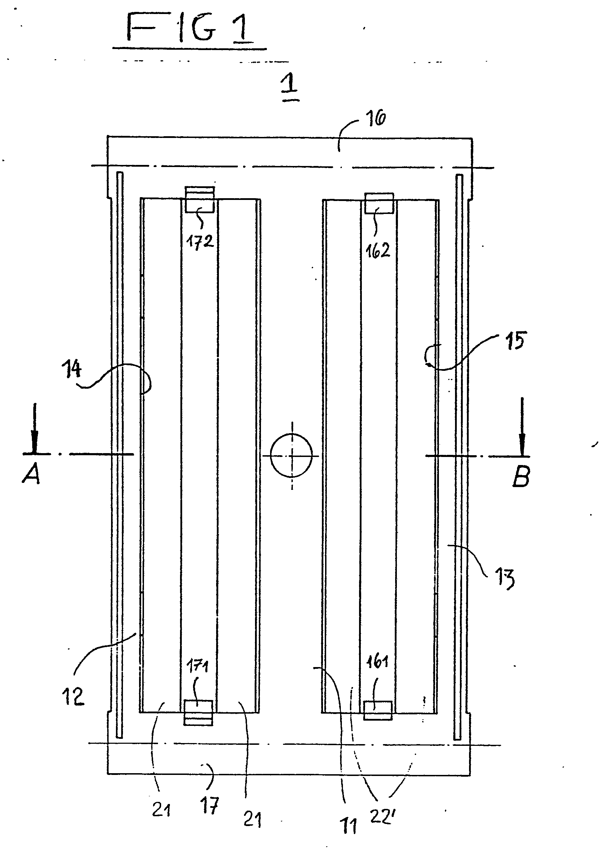

Gleiche Elemente in den Fig. 1 bis 3 sind mit gleichen Bezugzeichen markiert.

Ein Formteil (1 in Fig. 1) ist ein rechteckiger, fensterähnlicher Rahmen mit drei geraden Schenkeln, einem Mittenschenkel 11 und zwei Aussenschenkeln 12, 13, und mit zwei Durchbrüchen 14, 15 zwischen je einem der Aussenschenkel und dem Mittenschenkel. Derartige Formteile bestehen aus einem Isolierkunststoff, z. B. aus Polykarbonat, und sind zu zweien in dieser Form als Abschliesskörper für je einen aus zwei Kühlkörpern 2, 2' zusammengesetzten Kühlkörperblock nach Fig. 2 an dessen zwei Stirnflächen St₁, St₂ zu verwenden, in welchem zwischen ebenen Auflageflächen der Kühlkörper eine oder mehrere Halbleiterscheibenzellen unter Kontaktdruck einspannbar sind. Zugleich wirken die Formteile jeweils zu zweien (1 und 1') als Halterung für die zwei Kühlkörper. Die Formteile selbst können z. B. mittels Gewindestangen getragen werden, die durch die vier nahe der Eckpunkte eines Formteils in dessen beiden Traversen 16, 17 eingebrachte Durchstecklöcher hindurchgehen. Mittels dieser Gewindestangen können dann zwei oder mehr Kühlkörperblöcke mit Kraftschluss zusammengespannt werden. Dabür werden zusätzliche Mittel, wie beispielsweise Distanzstücke, nicht benötigt. Der Kraftfluss wird von den Traversen aufgenommen, so dass keine unerwünschten Kräfte auf die Halbleiterzelle und die Halbleiter selbst übertragen werden.

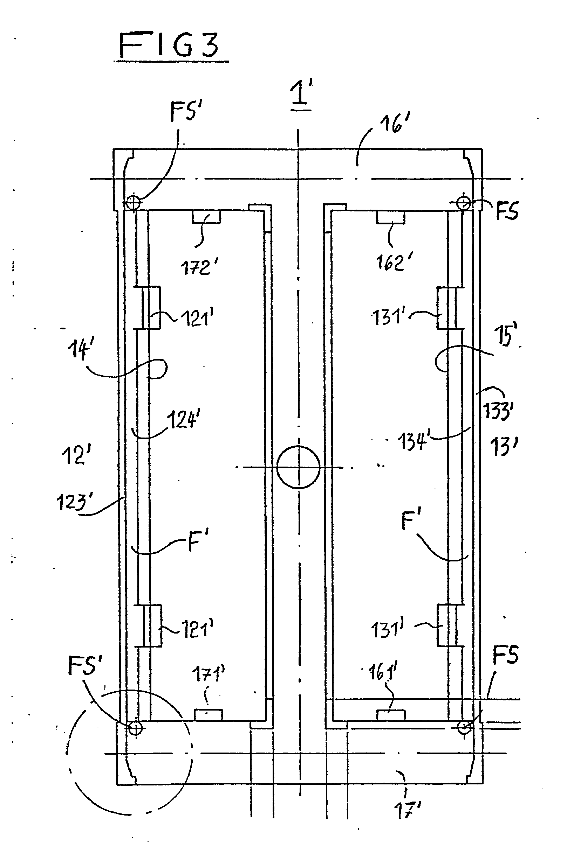

Die Formteile 1, 1' haben je zwei an der Innenfläche ihrer zwei Aussenschenkel 12, 13 bzw. 12', 13' angeformte federnde Haken 121, 131 bzw. 121', 131'. Die vier Aussenschenkel der zwei Formteile haben ferner (s. Fig. 3) an ihren Seitflächen 122, 132 bzw. 122', 132' je eine den zwei Kühlkörpern zugewandte Führung F, F', die länger als die Aussenschenkel und die vor den Enden der Traversen 16, 16' und 17, 17' offen sind zum Einschieben von zwei Isolierplatten. Diese Führungen sind schienenartig dadurch ausgebildet, dass die Aussenschenkel 12, 12' und 13, 13' der Formteile Winkel mit L-Profil sind, deren je zwei Winkelschenkel bei dem in Fig. 3 gezeigten Formteil 1' mit 123', 124' und 133', 134' bezeichnet sind. Hiervon sind die Winkelschenkel 123', 133' auf den Traversen 16' und 17' mit nach oben bzw. unten zunehmender Dicke fortgesetzt. Den Winkelschenkeln stehen je zwei Führungsstifte FS' gegenüber, die etwa so weit voneinander wie die Aussenschenkel lang sind beabstandet sind. Nach Fig. 2 sind bei den zwei Kühlkörpern an je einer Stirnseite zwei C-förmige Schienen 21, 22 bzw. 21', 22' angeformt, die als Anschlussspuren eines Kühlkörpers dienen. Die an den vorderen und hinteren Stirnseiten der zwei Kühlkörper angeformten C-förmigen Schienen sind unterschiedlich hoch und ragen unterschiedlich weit aus den Durchbrüchen heraus. Die zwei Formteile, Formteil 1 an der vorderen Stirnfläche St₁ und Formteil 1' an der hinteren Stirnfläche St₂ des Kühlkörperblocks, werden an denselben Stirnseiten so angebracht, dass die C-förmigen Schienen an ihren Längsseitflächen von den Durchbrüchen 14, 15 und 14', 15' der zwei Formteile 1 und 1' eingefasst sind und aus den Durchbrüchen herausragen. Dafür werden die Formteile so weit in Richtung auf die betreffenden Stirnflächen verschoben, bis die federnden Haken 121, 131 und 121', 131' die Längskanten des Bodens 211, 221, 211', 221' der Schienen einrastend umgreifen. Dadurch haben die Formteile an den Kühlkörpern des Blocks gegeneinander einen angepassten Sitz.

In die so ausgebildeten Führungen F' und auch F (beim Formteil 1) werden bei einem Kühlkörperblock von vorn oder hinten biegbare Isolierplatten durch die zwei Formteile seitlich ein- und hindurchgeschoben und dabei durch Verbiegungsspannung verriegelt. Der Fertigungstoleranzen ausgleichende, angepasste Sitz der Formteile an den Kühlkörpern wird durch folgende Massnahmen erreicht:

1. Bei den C-förmigen Schienen ist jeweils derjenige Teil 212, 121' (Schienenwand) zur Längskante des Bodens 211, 211' hin konisch verbreitert, an dem die federnden Haken aussen anliegen.

2. An den Rahmentraversen 16, 16' und 17, 17' der zwei Formteile 1 und 1' sind je zwei stegförmige Vorsprünge 161, 162; 161', 162'; 171, 172; 171', 172' angeformt, die als Anschläge der Formteile dienen und die paarweise auf den Mittenlinien der Durchbrüche liegen und in die Durchbrüche hineinragen.

Die an einem Kühlkörperblock angebrachten zwei Formteile 1', 1 können diesen an seiner vorderen und hinteren Stirnseite St₁, St₂ dicht abschliessen, wobei die Mittenschenkel der Formteile den freien Raum zwischen den einander zugewandten Kühlrippen der zwei Kühlkörper 2, 2' überdecken. Ausserdem überdecken die vier Aussenschenkel der zwei Formteile jeweils die Hälfte der zwei freien Räume, die zwischen dem Kühlkörperblock und zwei links und rechts hiervon unmittelbar benachbarten ebensolchen Blöcken bestehen. Kommen bei einem Kühlkörperblock noch die oben beschriebenen zwei Umkleidungsplatten hinzu, die an den zwei Seiten links und rechts des Kühlkörperblocks einschiebbar sind, dann ist hiermit ein Kühlblock mit und in einem vierseitigen geschlossenen Kühlluftschacht geschaffen.

**Patentansprüche**

1. Kühlkörperblock mit zwei Kühlkörpern (2, 2'), die mit einer oder mehreren zwischen sich an ebenen Auflageflächen unter Kontaktdruck eingespannten Halbleiter-Scheibenzellen zusammengehalten sind, mit jeweils einem an den vorderen und den hinteren Stirnseiten der zwei Kühlkörper angefügten Formteil (1, 1') aus einem Isolierkunststoff, dadurch gekennzeichnet, dass diese Formteile Rahmen (1, 1') sind mit geraden Mittenschenkeln (11, 11'), welche den freien Raum zwischen den einander zugewandten Kühlrippen der Kühlkörper (2, 2') abschliessen, und mit Aussenschenkeln (12, 13, 12', 13'), welche jeweils den halben freien Raum zwischen den Kühlrippen der Kühlkörper benachbart angeordneter Kühlkörperblöcke abschliessen, und dass die zwei Formteile jeweils mittels zweier von je einem Durchbruch (14, 14', 15, 15'), die beide durch den Mittenschenkel (11, 11') voneinander getrennt sind, umfasster und aus den Formteilen herausragender C-förmiger Schienen (21, 21', 22, 22'), die als elektrische Anschlussspuren der zwei Kühlkörper dienen und von denen jeweils eine an jeder Stirnseite (St₁, St₂) jedes Kühlkörpers angeformt ist, an gegenüberliegenden Stirnseiten des Kühlblocks verriegelbar sind.

2. Kühlkörperblock nach Anspruch 1, dadurch gekennzeichnet, dass die Kühlkörper in den Formteilen gelagert sind, dass die Formteile (1, 1') zu ihrer Verriegelung je zwei an der Innenfläche der zwei Aussenschenkel (12, 12', 13, 13') angeformte federnde Haken (121, 131, 121', 131') haben, die längs je einer C-förmigen Schiene (21, 21', 22, 22') aussen anliegen und die die äusseren Längskanten zum Boden (211, 211', 221, 221') der betreffenden Schiene einrastend umgreifen und die Formteile am Kühlkörperblock verankern.

3. Kühlkörperblock nach Anspruch 1, dadurch gekennzeichnet, dass die zwei Aussenschenkel (12, 13, 12', 13') der Formteile (1, 1') an den Seitflächen (122, 122', 132, 132'), welche den Kühlkörpern zugewandt sind, je eine Führung (F, F') zum Einschieben von Isolierplatten haben, die zusammen mit den zwei Formteilen eine den Kühlkörper schachtartig umschliessende Umkleidung bilden.

4. Kühlkörperblock nach Anspruch 1, dadurch gekennzeichnet, dass die an den vorderen und hinteren Stirnseiten (St, St') der zwei Kühlkörper angeformten C-förmigen Schienen (21, 22, 21', 22') unterschiedlich hoch sind und unterschiedlich weit aus den Durchbrüchen der Formteile (1, 1') herausragen.

## Claims

1. Cooling body block with two cooling bodies (2, 2'), which are held together with one or more semiconductor disc cells clamped between them under contact pressure at planar contact surfaces, with a respective moulded part (1, 1') of an insulating synthetic material placed against the front and rear end faces of the two cooling bodies, characterised thereby, that these moulded parts are frames (1, 1') with straight middle limbs (11, 11'), which close off the free space between the mutually facing cooling ribs of the cooling bodies (2, 2'), and with outer limbs (12, 13, 12', 13'), which respectively close off half the free space between the cooling ribs of the cooling bodies of adjacently arranged cooling body blocks, and that the two moulded parts are each latchable at oppositely disposed end faces of the cooling block by means of two C-shaped rails (21, 21', 22, 22'), which serve as electrical connecting tracks of the cooling bodies, project out from the moulded parts and are framed by a respective one of two passages (14, 14', 15, 15'), which are both separated each from the other by the middle limb (11, 11'), and of which a respective one is shaped on at each end face (St₁, St₂) of each cooling body.

2. Cooling body block according to claim 1, characterised thereby, that the cooling bodies are borne in the moulded parts and that the moulded parts (1, 1') for their latching have two respective resilient hooks (121, 131, 121', 131'), which are shaped on at the inside surface of each of the two outer limbs (12, 12', 13, 13'), lie externally against a respective C-shaped rail (21, 21', 22, 22'), engage with detent around the outer longitudinal edges to the base (211, 211', 221, 221') of the rail concerned and which anchor the moulded parts at the cooling body block.

3. Cooling body block according to claim 1, characterised thereby, that the two outer limbs (12, 12', 13, 13') of the moulded parts (1, 1') at the side surfaces (122, 122', 132, 132'), which face the cooling bodies, each have a guide (F, F') for the insertion of insulating plates which together with the two moulded parts form a cladding enclosing the cooling body in the manner of a shaft.

4. Cooling body block according to claim 1, characterised thereby, that the C-shaped rails (21, 22, 21', 22'), which are shaped on at the front and rear end faces (St, St') of the two cooling bodies, are differently high and project differently far out of the passages of the moulded parts (1, 1').

## Revendications

1. Bloc de deux radiateurs (2, 2'), qui sont assemblés avec un ou plusieurs disques semiconducteurs fixés par une pression de contact entre des portées planes, avec une pièce moulée (1, 1') en matière plastique isolante ajoutée sur les faces frontales avant et arrière des deux radiateurs, ledit bloc étant caractérisé en ce que les pièces moulées sont des cadres (1, 1') avec des branches médianes (11, 11') qui délimitent l'espace libre entre les ailettes de refroidissement en regard des radiateurs (2, 2'), et avec des branches extérieures (12, 13, 12', 13') qui délimitent chacune la moitié de l'espace libre entre les ailettes de refroidissement des radiateurs de blocs voisins; et les deux pièces moulées sont verrouillables chacune sur l'espace frontal en regard du bloc par deux rails en C (21, 21', 22, 22') entourés chacun par une ouverture (14, 14', 15, 15'), séparés par la branche médiane (11, 11'), en saillie sur les pièces moulées, servant de pistes de raccordement électrique des deux radiateurs, et dont un est formé sur chaque face frontale (St₁, St₂) de chaque radiateur.

2. Bloc de radiateurs selon revendication 1, caractérisé en ce que les radiateurs sont montés dans les pièces moulées (1, 1') qui comportent chacune pour leur verrouillage deux crochets élastiques (121, 131, 121', 131') formés sur la face intérieure des deux branches extérieures (12, 12', 13, 13'), s'appliquant chacun le long et à l'extérieur d'un rail en C (21, 21', 22, 22'), et entourant avec encliquetage les arêtes longitudinales extérieures en direction de la base (21, 211', 221, 221') du rail considéré, en fixant les pièces moulées sur le bloc de radiateurs.

3. Bloc de radiateurs selon revendication 1, caractérisé en ce que les deux branches extérieures (12, 13, 12', 13') des pièces moulées (1, 1') comportent chacune sur les faces latérales (122, 122′, 132, 132′) en regard des radiateurs un guide (F, F′) pour l'insertion des plaquettes isolantes qui, avec les deux pièces moulées, forment un revêtement entourant le radiateur à la façon d'une cheminée.

4. Bloc de radiateurs selon revendication 1, caractérisé en ce que les rails en C (21, 22, 21′, 22′) formés sur les faces frontales avant et arrière (St, St′) des deux radiateurs présentent une hauteur différente et une saillie différente sur les ouvertures des pièces moulées (1, 1′).

FIG 1

# FIG 2

a)

b)

# FIG 3